# EUROPÄISCHE PATENTANMELDUNG

(11) **EP 1 732 138 A2**
(43) Veröffentlichungstag der Anmeldung: **13.12.2006**
(21) Anmeldenummer: 06011508.6
(22) Anmeldetag: 02.06.2006
(51) Int. Cl.: H01L 31/0224, H01L 21/00

(54) **Verfahren zur flächigen Kontaktierung von Halbleiterbauelementen mit reduzierter Durchbiegung sowie entsprechendes Halbleiterbauelement und Herstellungsvorrichtung**

(30) Priorität: 06.06.2005 DE 102005026176
(71) Anmelder: Universität Konstanz, 78464 Konstanz (DE)
(72) Erfinder: Huster, Frank, 04105 Leipzig (DE)
(74) Vertreter: Klunker . Schmitt-Nilson . Hirsch

(57) **Zusammenfassung**

Es wird ein Verfahren zur flächigen Kontaktierung eines Halbleiterbauelement mit einem Kontaktierungsmaterial, eine zur Durchführung des Verfahrens geeignete Vorrichtung und ein entsprechend herstellbares Halbleiterbauelement vorgestellt. Hierbei wir durch Abkühlen eines Kontaktierungsmaterials unter Raumtemperatur eine Reduzierung von thermisch bedingten mechanischen Spannungen innerhalb des Bauelements und eine Reduzierung einer daraus resultierenden Durchbiegung erreicht.

## Beschreibung

### Gebiet der Erfindung

Die vorliegende Erfindung betrifft die großflächige Kontaktierung von Halbleiterbauelementen wie z.B. Siliziumsolarzellen, entsprechend kontaktierte Halbleiterbauelemente sowie eine Vorrichtung, wie sie bei der erfindungsgemäßen Kontaktierung verwendbar ist. Insbesondere betrifft die vorliegende Erfindung die Reduzierung einer durch mechanische Spannungen bedingten Durchbiegung (in Fachkreisen auch als "bow" bekannt), wie sie beispielsweise bei der flächigen Metallkontaktierung von Solarzellen gemeinhin auftritt.

### Hintergrund der Erfindung

Solarzellen sind ein spezieller Typ von Halbleiterbauelementen. Um möglichst viel Sonnenlicht einzufangen, müssen die Solarzellen eine flächige Geometrie aufweisen. Typische kommerziell erhältliche Solarzellen auf der Basis von Siliziumwafersubstraten, wie sie etwa 80% der weltweiten Solarzellenproduktion ausmachen, weisen derzeit eine Fläche von mindestens 10x10cm² und eine Dicke von etwa 300µm auf. Um Produktionskosten und teures Siliziumsubstratmaterial einzusparen geht der Trend jedoch hin zu großflächigeren Zellen mit einer reduzierten Dicke von weniger als 200µm.

Die meisten industriell hergestellten Siliziumsolarzellen werden durch eine Herstellungssequenz gefertigt, die zumindest die folgenden wesentlichen Schritte umfasst: In einen Siliziumwafer wird eine Emitterschicht oberflächlich eindiffundiert. Die hierdurch entstehende flächige pn-Diode wird an ihrer Vorderseite mit einem Netzwerk aus dünnen Metallkontakten und an ihrer Rückseite mit einem ganzflächigen Metallkontakt kontaktiert.

Industriell werden die Kontakte meist im Siebdruckverfahren auf die Wafer aufgedruckt und anschließend bei hoher Temperatur eingefeuert. Hierbei wird eine metallhaltige Dickfilmpaste durch ein Sieb entsprechender Geometrie auf der Wafervorderseite gitterförmig und auf der Waferrückseite flächig aufgedruckt. Nach dem Aufdrucken wird die Paste zunächst getrocknet und dann in einem Feuerofen bei über 600°C in den Wafer eingebrannt. Bei dieser Temperatur wird eine in der Dickfilmpaste enthaltene sogenannte Glasfritte, d.h. kleine Partikel zumeist aus verschiedenen Metalloxiden, flüssig und frisst sich teilweise in die Oberfläche des Wafers. Auf diese Weise wird eine Matrix aus Glasfritte und ebenfalls in der Dickfilmpaste enthaltenen Metallbestandteilen gebildet, die nach dem Abkühlen und Erstarren der Glasfritte und der gegebenenfalls ebenfalls geschmolzenen Metallbestandteile die Metallkontakte der Solarzelle bilden. Über diese Metallkontakte kann die von der Solarzelle erzeugte elektrische Leistung nach außen hin zu einem Verbraucher geleitet werden.

Für den flächigen Rückkontakt wird industriell meist eine aluminiumhaltige Dickfilmpaste verwendet. Das Aluminium bewirkt mehrere Vorteile: es bildet oberhalb von 577°C an der Grenzfläche zu dem Siliziumwafer zusammen mit dem Silizium des Wafers ein Eutektikum, also eine flüssige Phase aus Aluminium und Silizium, die nach deren Abkühlen und Erstarren zu einer sehr guten mechanischen und elektrischen Verbindung der darüber liegenden Aluminiumschicht mit der Solarzelle führt. Weiterhin bewirkt das einlegierte Aluminium ein sog. BSF (back surface field), welches durch seine elektrische Passivierung der Rückseitenoberfläche der Solarzelle zu einer Wirkungsgradsteigerung der Zelle führt.

Die Verwendung eines flächigen Aluminumrückkontakts führt jedoch bei herkömmlichen Fertigungsverfahren zu folgendem Problem: Nachdem das Aluminium bei über 577°C, der eutektischen Temperatur des Al-Si-Gemischs, in das Silizium einlegiert wurde, wird die derart kontaktierte Solarzelle auf Raumtemperatur abgekühlt. Bei Unterschreiten der eutektischen Temperatur erstarrt das Al-Si-Gemisch. Sowohl das Al-Si-Gemisch wie auch das eventuell darüber liegende reine Aluminium hat einen thermischen Längenausdehnungskoeffizienten, der größer ist als derjenige von Silizium. Das bedeutet, dass sich die erstarrte Al- bzw. Al-Si-Schicht beim Abkühlen der Solarzelle stärker kontrahiert als das Silizium. Dies führt dazu, dass derart herkömmlich hergestellte Siliziumsolarzellen stets eine durch die unterschiedliche Kontraktion der verschiedenen Materialien bewirkte mechanische Spannung aufweisen, die ähnlich wie bei einem Bimetall zu einer Durchbiegung der Zelle führt.

Eine derartige Durchbiegung stellt ein seit langem bekanntes und bisher ungelöstes Problem bei der Solarzellenfertigung dar. Die Durchbiegung erschwert eine weitere Verarbeitung der Solarzelle. Insbesondere beim Verlöten der Metallkontakte sowie beim Einkapseln der Solarzelle erhöht sie das Risiko eines Brechens der spröden Siliziumsolarzelle. Das Ausmaß der Durchbiegung hängt neben der Geometrie des Siliziumwafers, d.h. dessen Breite und Dicke, auch von der Schichtdicke der Al- bzw- Al-Si-Schicht ab. Bei der industriellen Herstellung herkömmlicher Solarzellen mit einer typischen Dicke von etwa 300µm wurde bisher eine Durchbiegung von bis zu etwa 1,5mm als tolerabel angesehen. Eine zu starke Durchbiegung erhöht das Bruchrisiko für die Solarzelle bei späteren Verarbeitungsschritten, beispielsweise bei der Einkapselung der Zelle, bei der diese flach gedrückt wird. Durch die entstehenden mechanischen Spannungen kann auch eine Langzeitstabilität der Zelle gefährdet sein und sich deren Lebensdauer beispielsweise aufgrund von Mikrorissen in der Zelle oder der Kontaktierung reduzieren.

Es besteht ein Bestreben von Seiten der Solarzellenindustrie, großflächigere Wafer dünnerer Dicke zu verarbeiten. Bei daraus hergestellten Solarzellen führt die durch die unterschiedliche Kontraktion des Metallrückkontakts und des Siliziumwafers bedingte mechanische Spannung zu einer nicht mehr tolerierbaren Durchbiegung der Solarzelle. Versuche mit Siliziumwafern einer Fläche von 15x15cm² und einer Dicke von unter 150µm ergaben bei herkömmlicher flächiger Rückseitenkontaktierung mit Al-haltiger Siebdruckpaste eine Durchbiegung von wesentlich mehr als 2mm, es wurden teilweise bis zu 5mm Durchbiegung geobachtet. Es sind unter anderem die dadurch bewirkten Probleme bei der anschließenden Weiterverarbeitung der Solarzelle, die bisher eine industrielle Fertigung dünnerer und damit kostensparender Siliziumsolarzellen verhindert haben.

### Stand der Technik

Es wurden verschiedene Ansätze gemacht, das oben beschriebene Problem der Durchbiegung der flächig kontaktierten Solarzellen zu lösen. Beispielsweise wurde die flächige Rückseitenkontaktierung durch eine gitternetzartige Kontaktierung ersetzt. Dies mindert zwar die Problematik der Durchbiegung. Gleichzeitig entfällt aber auch die positive Wirkung des flächigen Aluminium-BSF. Entweder sinkt der Wirkungsgrad der Solarzelle oder die oberflächenpassivierende Wirkung des Al-BSF muss durch andere Maßnahmen, z.B. eine Siliziumnitridabscheidung auf die Waferoberfläche, ersetzt werden, was zusätzliche Kosten und Arbeitsschritte erforderlich macht.

Auch das Ausbilden der Al- bzw- Al-Si-Schicht in reduzierter Schichtdicke, um eine durch diese Schichten bewirkte, die Durchbiegung der Zelle hervorrufende Kraft zu reduzieren, führt zu einer unerwünschten Verschlechterung der rückseitigen Oberflächenpassivierung der Solarzelle durch das dünnere Al-BSF.

In einem anderen, in der deutschen Patentanmeldung DE-103 26 274 A1 verfolgten Ansatz werden der für den flächigen Rückkontakt verwendeten Al-Siebdruckpaste spezielle Glasfritte beigemischt. Diese sollen bewirken, das der thermische Ausdehnungskoeffizient des Rückkontakts kleiner wird und sich somit die beim Abkühlen der Zelle nach dem Einfeuern des Rückkontakts entstehenden mechanischen Spannungen verringern. Die auf diese Weise bewirkte Verringerung der Durchbiegung der Solarzelle hat sich aber bisher in der industriellen Fertigung als noch nicht ausreichend erwiesen.

Auch ein besonders langsames Abkühlen der mit dem Rückkontakt versehenen Solarzelle oder ein Tempern bei einer Temperatur unterhalb der eutektischen Temperatur, beispielsweise zwischen 300°C und 500°C, konnte bisher eine durch die mechanische Spannung an der Grenzschicht Aluminiumkontakt-Siliziumwafer bedingte Durchbiegung der Solarzelle nicht ausreichend reduzieren.

### Aufgabenstellung und Beschreibung der Erfindung

Es ist eine Aufgabe der vorliegenden Erfindung, die oben beschriebenen Probleme und Mängel des Standes der Technik zu mindern.

Es ist insbesondere eine Aufgabe der vorliegenden Erfindung, ein Verfahren zur flächigen Kontaktierung eines Halbleiterbauelements, insbesondere einer Solarzelle, vorzusehen, bei dem eine Durchbiegung des kontaktierten Halbleiterbauelements minimiert ist, sowie eine zur Durchführung des erfindungsgemäßen Verfahrens ausgelegte Vorrichtung vorzuschlagen. Das Verfahren soll kostengünstig und mit konventionellen Herstellungsverfahren kompatibel sein.

Es ist ebenfalls eine Aufgabe der vorliegenden Erfindung, ein Halbleiterbauelement, beispielsweise eine Solarzelle auf Basis eines dünnen Siliziumwafers, bereitzustellen, das keine oder eine tolerierbar geringe Durchbiegung aufweist.

In einem ersten Aspekt sieht die Erfindung ein Verfahren zur flächigen Kontaktierung eines Halbleiterbauelementsubstrats vor. Das Verfahren weist die folgenden Schritte auf: Bereitstellen eines Halbleiterbauelementsubstrats; Aufbringen eines Kontaktierungsmaterials auf eine Oberfläche des Halbleiterbauelementsubstrats; Erhitzen des Halbleiterbauelementsubstrats einschließlich des darauf aufgebrachten Kontaktierungsmaterials auf eine erste Temperatur oberhalb einer Fertigungstemperatur des Halbleiterbauelements; und Abkühlen des Halbleiterbauelementsubstrats einschließlich des darauf aufgebrachten Kontaktierungsmaterials auf eine zweite Temperatur, wobei die zweite Temperatur unterhalb der Fertigungsumgebungstemperatur des Halbleiterbauelements liegt.

Das Halbleiterbauelementsubstrat kann beispielsweise ein Siliziumwafer sein, wie er für die Fertigung herkömmlicher Siliziumsolarzellen verwendet wird. Der Siliziumwafer kann bereits vorhergehende Bearbeitungsschritte durchlaufen haben, beispielsweise eine Reinigung, eine Diffusion, um in ihm einen pn-Übergang zu erzeugen, und einen Metallisierungsschritt, um einen gitterförmigen Frontkontakt auf der Vorderseite aufzubringen.

Alternativ kann das erfindungsgemäße Verfahren jedoch auch auf Halbleiterbauelementsubstrate anderen Typs angewendet werden. Es ist insbesondere für die Herstellung solcher Halbleiterbauelemente vorteilhaft, bei denen ein Kontaktierungsmaterial großflächig auf das flächige Halbleiterbauelementsubstrat aufgebracht wird, beispielsweise in einem anschließenden Verarbeitungsschritt starken Temperaturschwankungen ausgesetzt wird und so das flächige Halbleiterbauelementsubstrat mit dem darauf aufgebrachten Kontaktierungsmaterial nach dem Abkühlen aufgrund unterschiedlicher thermischer Ausdehnungskoeffizienten der Materialien des Substrats und des Kontakts mechanischen Spannungen unterliegt und sich gegebenenfalls durchbiegt.

Unter einem flächigen Substrat wird hierbei ein solches Substrat verstanden, bei dem die Abmessungen der Oberfläche, auf die das Kontaktierungsmaterial aufgebracht wird, wesentlich, z.B. mehr als 300-fach, größer ist als die Dicke des Substrats. Ein Beispiel ist ein Wafer von mindestens 10x10cm² Fläche und 300µ m Dicke. Eine flächige Kontaktierung soll hierbei bedeuten, dass zumindest 50% einer Oberfläche des Substrats mit dem Kontaktierungsmaterial bedeckt sind.

Als Kontaktierungsmaterial werden derzeit in der Halbleiterindustrie meist Metalle verwendet. Prinzipiell sind aber auch andere nicht-metallische Kontaktierungsmaterialien denkbar, wie z.B. elektrisch leitende Polymerschichten. Das Kontaktierungsmaterial kann auf verschiedene Weisen auf das Halbleiterbauelementsubstrat aufgebracht werden. Beispielsweise ist es bei industriell gefertigten Siliziumsolarzellen üblich, das Kontaktierungsmaterial in Form einer metallhaltigen Dickfilmpaste mittels Siebdruck auf die Substratoberfläche aufzubringen. Das Kontaktierungsmaterial kann aber auch durch andere Abscheidungsverfahren aufgebracht werden, wie z.B. Aufdampfen, Aufsputtern, galvanisches oder stromloses Plattieren oder Aufbringen und Verbinden einer Metallfolie mit der Substratoberfläche.

Das erfindungsgemäße Erhitzen des Substrats auf die erste Temperatur oberhalb der Fertigungsumgebungstemperatur kann in verschiedenen Arten von Öfen erfolgen. Bei der industriellen Solarzellenfertigung werden beispielsweise meist Durchlauföfen verwendet, bei denen die mit dem Kontaktierungsmaterial versehenen Substrate auf einen Gürtel gelegt werden und mittels dieses Gürtels durch eine Heizzone transportiert werden, in der das Kontaktierungsmaterial auf so hohe Temperaturen erhitzt wird, dass sich zumindest Teile des Kontaktierungsmaterials verflüssigen. Typischerweise liegt diese erste Temperatur im Bereich von 600 bis 900°C. Die erste Temperatur liegt somit weit oberhalb der Fertigungsumgebungstemperatur. Unter der Fertigungsumgebungstemperatur wird hierbei diejenige Temperatur verstanden, die typischerweise bei den Verarbeitungsschritten des Halbleiterbauelements abgesehen von den Hochtemperaturschritten herrscht, d.h. die Umgebungslufttemperatur in einer Fertigungslinie von typischerweise zwischen 10°C und 40°C. Insbesondere kann unter der Fertigungsumgebungstemperatur die Temperatur verstanden werden, wie sie bei der anschließenden Weiterverarbeitung, beispielsweise der Einkapselung, des mit dem flächigen Kontakt versehenen Bauelements herrscht.

Erfindungsgemäß wird das Kontaktierungsmaterial nach dem Erhitzen auf eine zweite Temperatur unterhalb der Fertigungsumgebungstemperatur abgekühlt. Das heißt, das Substrat einschließlich des darauf aufgebrachten Kontaktierungsmaterials wird nicht nur einfach passiv auf Raumtemperatur abkühlen gelassen, sondern aktiv unter Raumtemperatur gekühlt. Die Kühlung kann dabei, wie weiter unten beschrieben, auf vielfältige Weise erfolgen. Nach dem Abkühlen erwärmt sich das Substrat wieder und wird bei der Fertigungsumgebungstemperatur weiterverarbeitet.

In einer Ausführungsform liegt die durch aktive Kühlung zu erreichende zweite Temperatur unterhalb von 0°C und vorzugsweise unterhalb von -40°C.

In einer weiteren Ausführungsform liegt die zweite Temperatur mindestens 25 K, vorzugsweise mindestens 65 K unterhalb der Fertigungsumgebungstemperatur.

In einer weiteren Ausführungsform ist die erste Temperatur so gewählt, dass sie oberhalb einer Verflüssigungstemperatur liegt, bei der das Kontaktierungsmaterial auf dem Substrat eine flüssige Phase bildet. Diese Verflüssigungstemperatur muss nicht notwendigerweise gleich oder höher als die Schmelztemperatur einer der Komponenten des Kontaktierungsmaterials sein. Beispielsweise wird in der Siliziumsolarzellenindustrie häufig eine Aluminiumsiebdruckpaste verwendet. Das darin enthaltene Aluminium hat eine Schmelztemperatur von etwa 660°C. Die ebenfalls in der Paste enthaltenen Glasfritte schmelzen typischerweise bei noch höheren Temperaturen. Allerdings bildet Aluminium zusammen mit Silizium bereits bei einer Verflüssigungstemperatur von 577° ein flüssiges Eutektikum. Es kann daher genügen, die erste Temperatur oberhalb von 577°C zu wählen. Allerdings ist anzumerken, dass die Aluminiumpartikel der Siebdruckpasten gewöhnlich von einer Oxidschicht überzogen sind, was die Bildung eines Eutektikums verhindern kann. Vorzugsweise wird daher die erste Temperatur oberhalb von 660°C gewählt.

Um eine gute elektrische und mechanische Verbindung des Kontaktierungsmaterials mit dem Substrat zu erreichen, reicht es somit aus, beide auf die erste Temperatur oberhalb der Verflüssigungstemperatur zu erhitzen und anschließend auf die mehrere hundert Kelvin niedrigere Fertigungsumgebungstemperatur abkühlen zu lassen, wobei die flüssige Phase wieder erstarrt.

In einer weiteren Ausführungsform weist das Kontaktierungsmaterial Metall auf.

In einer weiteren Ausführungsform weist das Kontaktierungsmaterial insbesondere Aluminium auf. Wie oben beschrieben, kann das Aluminium mit Silizium bereits bei relativ niedrigen Temperaturen ein Al-Si-Eutektikum bilden. Die geringere Prozesstemperatur verringert sowohl die Prozessierungskosten als auch das Risiko der Eindiffusion von Verunreinigungen in das Halbleiter-Bulk-Material. Weiterhin dient das stark Al-dotierte Silizium als BSF und dient somit als Oberflächenpassivierung der mit dem Metallkontakt flächig versehenen Halbleiteroberfläche. Ohne eine solche Oberflächenpassivierung würde es an der Oberfläche zu einer starken Ladungsträgerrekombination kommen, was z.B. im Fall von Siliziumsolarzellen den Wirkungsgrad erheblich senkt.

Es sei jedoch darauf hingewiesen, dass das erfindungsgemäße Verfahren auch bei der Kontaktierung mit silberhaltigen Siebdruckpasten anwendbar ist. Das Silber bildet bei üblichen Feuertemperaturen meist keine flüssige Phase mit einem Si-Substrat. Denoch kommt es durch einen Sinterprozeß zu einer festen mechanischen Verbindung des Silberkontakts mit dem Substrat und daher entstehen beim Abkühlen von Feuer- auf Umgebungstemperaturen ebenfalls thermisch bedingte mechanische Spannungen.

In einer weiteren Ausführungsform wird das Kontaktierungsmaterial in Form einer metallhaltigen Siebdruckpaste, beispielsweise einer aluminiumhaltigen Siebdruckpaste, auf die Oberfläche des Halbleiterbauelementsubstrats aufgebracht. Solche Siebdruckpasten sind im Stand der Technik weithin bekannt.

Gemäß einer weiteren Ausführungsform wird die erste Temperatur oberhalb einer Eutektischer-Punkt-Temperatur gewählt. Die Eutektischer-Punkt-Temperatur ist hierbei die Temperatur, bei der das in dem Kontaktierungsmaterial enthaltene Metall mit dem Material des Halbleiterbauelementsubstrats eine Legierung bzw. ein Eutektikum bildet.

In einer weiteren Ausführungsform hat das Kontaktierungsmaterial nach dem Erhitzen auf die erste Temperatur und einem anschließenden Abkühlen auf die Fertigungsumgebungstemperatur einen thermischen Ausdehnungskoeffizienten, der anders ist als der thermische Ausdehnungskoeffizient des Materials des Halbleitersubstrats. Gewöhnlich ist der Ausdehnungskoeffizient eines metallhaltigen Kontaktierungsmaterials größer als derjenige eines Halbleitersubstrates.

Wird beispielsweise eine metallhaltige Siebdruckpaste als Kontaktierungsmaterial verwendet, ändert diese durch Erhitzen auf die erste Temperatur und anschließendes Abkühlen ihre ursprünglich zähflüssige Konsistenz u.a. durch Verdampfen von Lösungsmitteln in eine feste Matrix aus Metallpartikeln und Glasfritten. Diese Matrix dient später als elektrischer Kontakt des Halbleiterbauelements. Die Matrix hat einen erheblich größeren thermischen Ausdehnungskoeffizienten als derjenige des Halbleitersubstrats. Es wurden Ausdehnungskoeffizienten für den Al-Kontakt von etwa 23*10⁻⁶ K⁻¹ und für Silizium von etwa 3*10⁻⁶ K⁻¹ gemessen. Das bedeutet, dass sich die Matrix beim Abkühlen auf die Fertigungsumgebungstemperatur stärker zusammenzieht, d.h. ihre Flächenausdehnung verkürzt, als das Halbleitersubstrat. Hierdurch entstehen an der Grenzschicht zwischen Matrix und Substrat mechanische Spannungen, die zu einem Verbiegen des Substrats führen können, ähnlich wie bei einem Bimetall.

In einer weiteren Ausführungsform erfolgt das Abkühlen des Kontaktierungsmaterials auf die zweite Temperatur zumindest teilweise durch Einbringen des Subtrates samt Kontaktierungsmaterial in einen Raum, dessen Wände auf die zweite Temperatur oder darunter gekühlt sind. Durch Strahlungsaustausch mit den Wänden wird das Kontaktierungsmaterial ebenfalls auf die zweite Temperatur gekühlt. Ein solches strahlungsbedingtes Abkühlen funktioniert insbesondere bei Siliziumsolarzellen gut, da bei ihnen die Oberfläche des Kontaktierungsmaterials im Vergleich zum Volumen der Zelle sehr groß ist, was eine Wärmeabgabe durch Strahlung begünstigt. Ein Strahlungsaustausch kann dadurch noch unterstützt werden, dass die gekühlten Wände dunkel, vorzugsweise schwarz, gehalten sind.

Gemäß einer anderen Ausführungsform erfolgt das Abkühlen des Kontaktierungsmaterials zumindest teilweise durch Umgeben desselben mit einem Gas, das auf die zweite Temperatur oder darunter gekühlt ist. Hierbei erfolgt der Wärmeaustausch zwischen dem Gas und dem Kontaktierungsmaterial über deren direkten Kontakt durch Wärmediffusion und Konvektion.

In einer anderen Ausführungsform erfolgt das Abkühlen des Kontaktierungsmaterials zumindest teilweise durch Aufbringen einer kalten Flüssigkeit mit einer Temperatur bei oder unter der zweiten Temperatur oder durch Aufbringen eines Kältesprays auf das Halbleiterbauelementsubstrat und/oder das Kontaktierungsmaterial. Unter einem Kältespray wird hierbei eine leicht flüchtige Flüssigkeit verstanden, die, wenn sie auf das Substrat und/oder das Kontaktierungsmaterial aufgebracht wird, schnell und vorzugsweise rückstandslos verdampft und das Kontaktierungsmaterial durch die dabei entzogene Verdampfungsenergie kühlt.

Gemäß einer weiteren Ausführungsform erfolgt das Abkühlen des Kontaktierungsmaterials auf die zweite Temperatur zumindest teilweise innerhalb derselben Vorrichtung wie das Erhitzen auf die erste Temperatur. Dies kann beispielsweise dadurch geschehen, dass das zu fertigende Bauelement in eine Vorrichtung eingebracht wird, die einen Prozessraum aufweist, der sowohl über Heizeinrichtungen als auch über Kühleinrichtungen verfügt. Das Bauelement wird in diesem Raum dann zunächst auf die erste Temperatur erhitzt, und anschließend wird entweder der gesamte Raum oder lediglich das Bauelement bzw. dessen Kontaktierungsmaterial auf die zweite Temperatur abgekühlt.

Alternativ kann die Vorrichtung zwei separate Bereiche aufweisen, wobei der erste Bereich auf der ersten Temperatur gehalten wird und der zweite Bereich auf der zweiten Temperatur gehalten wird und das Bauelement zunächst den ersten Bereich und anschließend den zweiten Bereich durchläuft. Eine für die Durchführung des erfindungsgemäßen Verfahrens geeignete Vorrichtung wird weiter unten im Detail beschrieben.

In einer weiteren Ausführungsform ist das Halbleiterbauelementsubstrat ein Siliziumwafer, und das zu fertigende Halbleiterbauelement ist eine Siliziumsolarzelle. Der Siliziumwafer kann dabei eine Dicke von weniger als 250 µm, vorzugsweise weniger als 200 µm und stärker bevorzugt weniger als 150 µm aufweisen. Aus den obigen Erläuterungen wird deutlich, dass die beschriebene Problematik der Durchbiegung eines solchen Siliziumwafers mit abnehmender Dicke kritischer wird.

Ein zweiter Aspekt der vorliegenden Erfindung ist auf ein Halbleiterbauelement mit einem auf einem Substrat flächig aufgebrachten Metallkontakt gerichtet. Das erfindungsgemäße Halbleiterbauelement ist beispielsweise mittels des oben beschriebenen Verfahrens herstellbar. Bei dem Halbleiterbauelement ist der Metallkontakt durch Abkühlen von einer Verflüssigungstemperatur, bei der das Material des Metallkontakts auf dem Material des Halbleiterbauelements bzw. dessen Substrat eine flüssige Phase bildet, auf eine Temperatur unterhalb einer Erstarrungstemperatur, bei der die flüssige Phase erstarrt, mit einer Oberfläche des Halbleiterbauelements bzw. dessen Substrat verbunden. Das Material des Metallkontakts hat dabei einen größeren thermischen Ausdehnungskoeffizienten als das Material des Halbleitersubstrats. Das Halbleiterbauelement aus dem Substrat und dem darauf aufgebrachten flächigen Kontakt ist nach dem Abkühlen bei einer Fertigungsumgebungstemperatur, wie sie weiter oben definiert wurde, weitgehend frei von mechanischen Spannungen.

Unter der weitgehenden Freiheit von mechanischen Spannungen kann dabei bei einer Ausführungsform verstanden werden, dass eine Durchbiegung des Halbleiterbauelements in einer Normalenrichtung normal zu dem flächigen Metallkontakt weniger als 0,5%, vorzugsweise weniger als 0,2% und stärker bevorzugt weniger als 0,1% der Abmessung des Halbleiterbauelements in einer Parallelenrichtung parallel zu dem flächigen Metallkontakt dividiert durch die Dicke des Halbleiterbauelements in der normalen Richtung ist. Unter der Durchbiegung kann dabei geometrisch der Abstand einer die Randpunkte des Bauelements an dessen einer Oberfläche verbindenden Sehne zu einer zu der Sehne parallelen Tangente an die gleiche Oberfläche verstanden werden. Anschaulicher ausgedrückt, kann die Durchbiegung beispielsweise einer Solarzelle als der Abstand verstanden werden, den ein Bereich der Rückseite der Solarzelle maximal von einer ebenen Fläche hat, wenn die Zelle mit ihrer Rückseite auf die ebene Fläche gelegt wird.

Am Beispiel einer Solarzelle mit einer Kantenlänge von 100 mm und einer Dicke von 300 µm bedeutet dies, dass die Durchbiegung zumindest weniger als (0,005x100/0,3)mm = 1,7 mm betragen sollte. Eine Solarzelle von 200 mm Seitenlänge und 200 µm Dicke sollte zumindest eine Durchbiegung von weniger als 5 mm, stärker bevorzugt jedoch eine Durchbiegung von weniger als 1 mm aufweisen.

Gemäß einer weiteren Ausführungsform kann die weitgehende mechanische Spannungsfreiheit des Bauelements durch ein Abkühlen des Metallkontakts auf eine Temperatur, die mindestens 25 K, vorzugsweise mindestens 65 K, unterhalb einer Fertigungsumgebungstemperatur des Halbleiterbauelements liegt, und anschließendes Erwärmen auf die Fertigungsumgebungstemperatur erreicht worden sein. Bei einer Fertigungsumgebungstemperatur von 25°C bedeutet dies beispielsweise eine Abkühlung auf 0°C bzw. vorzugsweise auf -40°C.

In einer weiteren Ausführungsform ist die weitgehende mechanische Spannungsfreiheit dadurch erhältlich, dass der Metallkontakt plastisch gereckt wurde. Dies kann, wie weiter unter genauer dargelegt, beispielsweise dadurch erfolgen, dass der Kontakt über die in ihm bei der Fertigungsumgebungstemperatur vorliegende mechanische Spannung weiter mechanisch belastet wird und es dadurch zu einem plastischen Fließen des Kontaktmaterials kommt, sodass sich die Geometrie des Kontakts dauerhaft verändert.

In einer speziellen Ausführungsform ist das Halbleiterbauelement eine Siliziumsolarzelle, die eine Dicke von weniger als 200 µm aufweist. Der Metallkontakt ist aluminiumhaltig und wurde bei einer Temperatur oberhalb der Eutektischer-Punkt-Temperatur von 577° des Al-Si-Gemisches einlegiert und anschließend auf unter 0°C, vorzugsweise auf unter -40°C, abgekühlt.

Ein dritter Aspekt der vorliegenden Erfindung ist schließlich auf eine Vorrichtung zum Verbinden, z.b. durch Einlegieren, eines auf eine Oberfläche eines Halbleiterbauelementsubstrats aufgebrachten Metallkontaktmaterials mit dem Substrat gerichtet. Die Vorrichtung weist eine Heizzone und eine Kühlzone auf.

Die Heizzone ist dazu ausgelegt, das Metallkontaktmaterial auf eine Temperatur oberhalb einer Verflüssigungstemperatur zu heizen, bei der das Metallkontaktmaterial auf dem Halbleiterbauelementssubstrat eine flüssige Phase bildet. Beispielsweise kann die Heizzone Infrarotstrahler aufweisen, um das Metallkontaktmaterial auf über 577°C, vorzugsweise über 660°C, zu erhitzen.

Die Kühlzone ist dazu ausgelegt, das auf das Halbleiterbauelementssubstrat aufgebrachte Metallkontaktmaterial auf eine Kühltemperatur von weniger als 25 K, vorzugsweise weniger als 65 K, unterhalb einer die Vorrichtung umgebenden Fertigungsumgebungstemperatur abzukühlen. Bei einer Raumtemperatur von beispielsweise 25°C, bei der das Halbleiterbauelement weiter verarbeitet wird, bedeutet dies eine Abkühlung auf 0°C bzw. vorzugsweise -40°C.

In einer Ausführungsform ist die erfindungsgemäße Vorrichtung mit einem Fördergürtel vorgesehen, um das Halbleiterbauelementssubstrat von der Heizzone in die Kühlzone zu transportieren. Das Substrat kann somit bei Raumtemperatur auf den Fördergürtel gelegt werden, wird von diesem dann in die Heizzone befördert, wo es auf die Verflüssigungstemperatur des Metallkontakts erhitzt wird, und wird dann von dem Fördergürtel weiter in die Kühlzone transportiert, wo der Metallkontakt unter Raumtemperatur abgekühlt wird.

lm Falle einer Siliziumsolarzelle erfolgt der Wärmeaustausch in der Heiz- bzw. Kühlzone aufgrund deren geringen Volumens und deren großer Oberfläche sehr schnell. Es genügt meist ein Aufenthalt in der Heiz- bzw. Kühlzone von wenigen Sekunden bis hin zu wenigen Minuten.

Um eine thermische Belastung des Fördergürtels zu reduzieren sowie den Wärmetransport von der Heizzone in die Kühlzone zu verringern, kann es gemäß einer weiteren Ausführungsform vorgesehen sein, einen Fördergürtel für den Transport des Substrats durch die Heizzone vorzusehen und einen weiteren, separaten Fördergürtel für den anschließenden Transport des Substrats durch die Kühlzone vorzusehen. Die beiden Fördergürtel sind dabei geometrisch so zueinander angeordnet, dass das Substrat problemlos und ohne übermäßig mechanische Belastung von dem einen zu dem anderen Fördergürtel hinüber gelangen kann.

Durch die Unterteilung in zwei separate Fördergürtel kann erreicht werden, dass nicht ein und derselbe Gürtel zunächst in der Heizzone erhitzt wird und anschließend in der Kühlzone zusammen mit den darauf transportierten Substraten abkühlen muss. Der Gürtel weist meist eine höhere Wärmekapazität (auch als "thermische Masse" bezeichnet) als die dünnen Substrate auf und würde daher langsamer als diese abkühlen. Durch getrennte Gürtel in Heiz- und Kühlzone kann der Abkühlvorgang somit beschleunigt werden.

In einer weiteren Ausführungsform weist die Kühlzone der erfindungsgemäßen Vorrichtung Kühlflächen auf, die auf oder unter die Kühltemperatur kühlbar sind. Um einen Wärmeaustausch durch Wärmestrahlung zwischen den Kühlflächen und den beispielsweise zwischen den Kühlflächen hindurch transportierten Substraten zu unterstützen, können die Kühlflächen dunkel, vorzugsweise schwarz, ausgebildet sein. Die Kühlflächen können an ihrer Rückseite mit einem Wärmetauscher versehen sein, der wiederum mit einem Kühlaggregat, ähnlich demjenigen eines Kühlschranks, verbunden ist.

in einer weiteren Ausführungsform weist die Vorrichtung in ihrer Kühlzone eine Gaszuführung auf, um das Metallkontaktmaterial durch Zuleiten eines Gases mit einer Temperatur bei oder unterhalb der Kühltemperatur zu kühlen. Durch die Gaszuführung kann das Gas direkt auf das Kontaktmaterial geleitet werden, und es kommt dort zu einem Wärmeaustausch und somit zu einer Kühlung des Kontaktmaterials.

In einer weiteren Ausführungsform weist die Vorrichtung in ihrer Kühlzone eine Flüssigkeitszuführung auf, um das Metallkontaktmaterial durch Zuleiten einer Flüssigkeit mit einer Temperatur bei oder unterhalb der Kühltemperatur oder durch Zuleiten eines Kältesprays zu kühlen. Durch die Flüssigkeitszuführung kann die kalte Flüssigkeit bzw. das Kältespray direkt auf das Metallkontaktmaterial oder das Substrat geleitet werden, wo es wiederum zu einem Wärmeaustausch und damit zur Kühlung kommt. Vorteilhafterweise verdampft dabei die gesamte zur Kühlung zugeführte Flüssigkeit rückstandslos und kann durch eine in der Vorrichtung vorgesehene Gasabsaugung abgesaugt werden.

Die oben beschriebenen und weitere Vorteile sollen anhand der nachfolgenden detaillierten Beschreibung einer bevorzugten Ausführungsform sowie den begleitenden Zeichnungen besser verstanden werden.

### Kurze Beschreibung der Zeichnungen

Fig. 1 zeigt schematisch eine Teilansicht einer erfindungsgemäßen Solarzelle, wie sie durch das erfindungsgemäße Verfahren herstellbar ist.
Fig. 2 zeigt schematisch einen erfindungsgemäßen Gürtelofen.

### Beschreibung bevorzugter Ausführungsformen

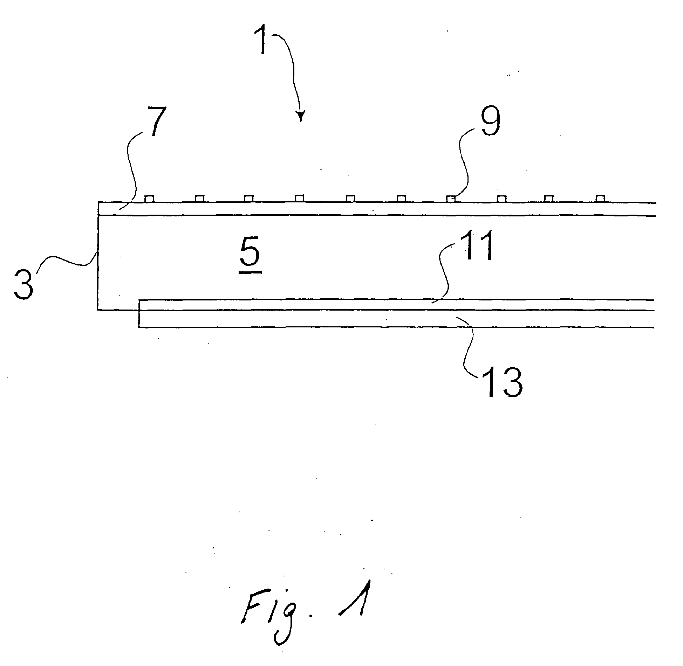

Fig. 1 zeigt eine erfindungsgemäße Siliziumsolarzelle 1. Die Solarzelle 1 weist ein Siliziumsubstrat 3 auf. Als Substrat 3 wurde ein etwa 200 µm dicker Siliziumwafer 5 vom p-Typ verwendet. Die Solarzelle 1 weist gitterförmige Frontkontakte 9 auf, die eine Emitterschicht 7 vom n-Typ kontaktieren. Auf der Rückseite der Solarzelle befindet sich über einem Aluminium-BSF 11 ein flächiger Rückkontakt 13.

Es wird nun eine Ausführungsform des erfindungsgemäßen Verfahrens beschrieben, mit deren Hilfe erreicht werden kann, dass die Solarzelle 1 mit dem darauf aufgebrachten flächigen Aluminiumrückkontakt 13 weitgehend frei von mechanischen Spannungen ist.

Nach einem Wegätzen eines Sägeschadens und einer Reinigung des Wafers 5 wird dieser einer Diffusion unterzogen. Dabei wird an einer Oberfläche des p-leitenden Wafers eine phosphorhaltige, n-leitende Emitterschicht 7 eindiffundiert. Auf die Emitterschicht 7 werden anschließend gitterförmige Frontkontakte 9 unter Verwendung einer silberhaltigen Dickfilmpaste und eines Siebes entsprechender Geometrie aufgedruckt. Die Frontkontakte 9 werden dann in einem Durchlaufofen getrocknet und anschließend bei einer Temperatur von 700 bis 900°C in die Emitterschicht 7 eingefeuert. Anschließend wird auf die Rückseite des Substrats 3 eine aluminiumhaltige Dickfilmpaste ganzflächig aufgedruckt. Ganzflächig bedeutet in diesem Zusammenhang, dass die gesamte Rückseite der Solarzelle bis auf eventuell einen frei bleibenden Rand von etwa 1 mm sowie eventuell nachfolgend mit einer silberhaltigen Paste zu kontaktierende Lötpad-Flächen mit der Aluminiumpaste bedeckt ist. Die Aluminiumpaste wird typischerweise in einer Dicke von 50 µm aufgetragen.

Anschließend wird die Aluminiumpaste in einem Durchlaufofen getrocknet. Danach kommt das Substrat 3 mitsamt der darauf aufgetragenen Aluminiumpaste auf den Gürtel eines Durchlauffeuerofens. Sie durchläuft eine oder mehrere Heizzonen, in der/denen sie auf eine Temperatur von über 660°C erhitzt wird. Bei dieser Temperatur bildet das in der Aluminiumpaste enthaltene Aluminium mit dem Silizium des Wafers 5 eine flüssige Al-Si-Phase.

Nachdem das Substrat 3 die Heizzone des Gürtelofens durchlaufen hat, kühlt es wieder auf annähernd Umgebungstemperatur ab. Unterhalb von 577° erstarrt dabei das Al-Si-Gemisch und bildet das stark Al-dotierte BSF 11. Über dem BSF 11 befindet sich der Aluminiumkontakt 13, der durch das Einlegieren elektrisch und mechanisch gut mit dem Substrat 3 verbunden ist.

Da der Aluminiumkontakt 13 jedoch einen größeren thermischen Ausdehnungskoeffizienten aufweist als der Siliziumwafer 5, entstehen durch das Abkühlen in dem Gürtelofen von 577°C auf Raumtemperatur mechanische Spannungen an der Grenzschicht zwischen Rückkontakt 13, BSF 11 und Wafer 5.

Um diese mechanischen Spannungen zu reduzieren, wird die bis hierher in herkömmlicher Weise hergestellte Solarzelle nun einem weiteren Verarbeitungsschritt unterzogen.

Die Zelle wird dabei durch Beströmen mit einem kalten Gas oder einer kalten Flüssigkeit, z.B. flüssigem Stickstoff, oder durch Aufsprühen eines Kältesprays auf eine Temperatur von etwa -40°C abgekühlt. Die durch die mechanischen Spannungen bewirkte Durchbiegung der Solarzelle bleibt hierbei zunächst erhalten bzw. nimmt sogar noch zu. Experimente haben jedoch ergeben, dass die Durchbiegung der Solarzelle beim anschließenden Erwärmen zurück auf Raumtemperatur erheblich abnimmt. Je nachdem, bis auf welche Temperatur die Solarzelle abgekühlt wurde, kann die Solarzelle nach dem Erwärmen auf Raumtemperatur sogar vollkommen eben sein. Dies ist ein deutlicher Hinweis darauf, dass die zuvor vorhandenen mechanischen Spannungen durch den zusätzlichen Verarbeitungsschritt des Abkühlens reduziert und im Idealfall sogar beseitigt wurden.

Es soll nun eine mögliche physikalische Erklärung dafür gegeben werden, weshalb die genannten mechanischen Spannungen durch den Abkühlverfahrensschritt abgebaut werden und somit die Durchbiegung der Solarzelle verringert wird.

Aufgrund der unterschiedlichen Ausdehnungskoeffizienten der Al- bzw. Al-Si-Schicht und des Siliziumwafers führt eine unterschiedlich starke Kontraktion der verschiedenen Schichten beim Abkühlen von der hohen Temperatur über 500°C auf etwa Raumtemperatur zu mechanischen Spannungen zwischen den Schichten. Die entstehenden mechanischen Spannungen führen teilweise zu einem Durchbiegen der Solarzelle. Sie führen aber weiterhin auch zu einer elastischen Dehnung der Al- bzw. Al-Si-Schicht.

Wie von dem Erfinder erstmals erkannt, scheint ein Anteil der mechanischen Spannungen, der nicht durch die Durchbiegung der Solarzelle und auch nicht durch die elastische Dehnung einer der Schichten aufgenommen wird, ein plastisches Dehnen der Schichten zu bewirken. Es kann in diesem Zusammenhang auch von einem plastischen Fließen innerhalb der meist porösen Struktur des Aluminiumrückkontakts bzw. des Al-Si-BSF gesprochen werden. Dieses plastische Fließen scheint schließlich zu einer bleibenden Verformung des Aluminiumrückkontakts bzw. des BSF während des Abkühlvorganges zu führen.

Eine weitere Abkühlung der Solarzelle unter die Raumtemperatur versucht nun eine weitere Kontraktion der Al- bzw. Al-Si-Schicht in Bezug auf den Siliziumwafer zu bewirken. Nur ein kleiner Teil der dadurch zusätzlich entstehenden mechanischen Spannung scheint dabei zu einer weiteren Verbiegung der Solarzelle bzw. zu einer elastischen Dehnung einer der Schichten zu führen. Ein erheblicher Teil der zusätzlichen mechanischen Spannung scheint ein weiteres plastisches Fließen innerhalb derjeweiligen Schichten zu bewirken.

Wird nun die Solarzelle wieder auf Raumtemperatur erwärmt, verbleiben die bei der tiefen Temperatur plastisch deformierten Schichten in ihrem Zustand, und es werden lediglich die zu der elastischen Dehnung der Schichten beitragenden mechanischen Spannungen und die zu der Verbiegung der Solarzelle beitragenden mechanischen Spannungen abgebaut.

Gemäß dieser möglichen physikalischen Erklärung bewirkt ein plastisches Fließen innerhalb der Al- bzw. Al-Si-Schicht bei Abkühlung auf tiefe Temperaturen eine bleibende Verformung dieser Schichten, die auch als eine Recken dieser Schichten angesehen werden kann, und ermöglicht dadurch einen spannungsfreien Zustand nach der anschließenden Erwärmung auf Raumtemperatur.

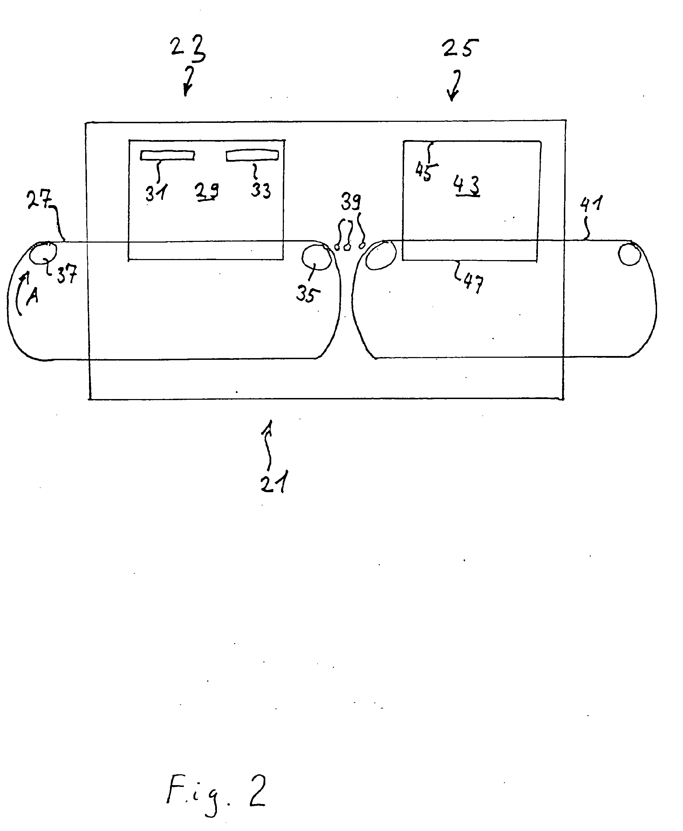

Abschließend wird die in Fig. 2 schematisch dargestellte erfindungsgemäße Vorrichtung kurz beschrieben. Die Vorrichtung 21 weist zwei Bereiche 23 und 25 auf. In dem ersten Bereich 23 befindet sich ein Fördergürtel 27, der durch Antriebsmittel (nicht dargestellt) in einer durch den Pfeil A veranschaulichten Richtung angetrieben wird. Der in sich geschlossene Fördergürtel 27 ragt in einem Randbereich seitlich aus der Vorrichtung 21 heraus, so dass zu verarbeitende Solarzellen von außen auf den Fördergürtel 27 gelegt werden können. Der Fördergürtel 27 transportiert die Solarzellen dann in den ersten Bereich 23, wo sie eine Heizzone 29 durchlaufen. In der Heizzone befinden sich Infrarotstrahler 31, 33, mit deren Hilfe die darunter hindurch laufenden Solarzellen auf Temperaturen oberhalb der Verflüssigungstemperatur erhitzt werden können. Die Solarzellen werden dann auf dem Gürtel 27 weitertransportiert und erreichen schließlich ein Ende der ebenen Erstreckung des Gürtels 27 im Bereich einer Umlenkrolle 35, hinter der sich der Gürtel 27 dann nach unten und letztendlich zu einer vorderen Umlenkrolle 37 bewegt.

Um die Solarzellen weiter zu einem in dem zweiten Bereich 25 befindlichen zweiten Fördergürtel 41 zu transportieren, sind kleine Transportrollen 39 vorgesehen. Diese Transportrollen können rotierend angetrieben sein.

Auf dem zweiten Fördergürtel 41 angekommen, werden die Solarzellen in eine Kühlzone 43 befördert. Diese Kühlzone 43 ist gegen die Heizzone 29 thermisch isoliert und weist den Fördergürtel 41 teilweise umgebende Wände 45, 47 (in der Zeichnung nur schematisch dargestellt) auf, die durch eine thermische Verbindung mit einer Kühleinrichtung auf eine Temperatur von -40°C gekühlt werden. Hauptsächlich durch Strahlungsaustausch kühlen die Solarzellen in der Kühlzone 43 auf weit unter 0°C ab. Anschließend werden sie durch den Fördergürtel 41 weiter befördert und können der Vorrichtung 21 an einem aus dieser seitlich hervorragenden Bereich des Fördergürtels 41 zur Weiterverarbeitung entnommen werden.

Die vorangehenden Ausführungsformen wurden lediglich beispielgebend beschrieben. Fachleute erkennen, das etwaige Modifikationen in den Umfang der beigefügten Ansprüche fallen können.

## Patentansprüche

1. Verfahren zur flächigen Kontaktierung eines Halbleiterbauelementsubstrats, aufweisend die folgenden Schritte:
Bereitstellen eines Halbleiterbauelementsubstrats;
Aufbringen eines Kontaktierungsmaterials auf eine Oberfläche des Halbleiterbauelementsubstrats;
Erhitzen des Halbleiterbauelementsubstrats einschließlich des darauf aufgebrachten Kontaktierungsmaterials auf eine erste Temperatur oberhalb einer Fertigungsumgebungstemperatur des Halbleiterbauelements; und
Abkühlen des auf das Halbleiterbauelementsubstrat aufgebrachten Kontaktierungsmaterials auf eine zweite Temperatur, wobei die zweite Temperatur unterhalb der Fertigungsumgebungstemperatur des Halbleiterbauelements liegt.

2. Verfahren nach Anspruch 1, wobei die zweite Temperatur unterhalb von 0°C liegt und vorzugsweise unterhalb von -40°C liegt.

3. Verfahren nach Anspruch 1, wobei die zweite Temperatur mindestens 25K, vorzugsweise mindestens 65K, unterhalb der Fertigungsumgebungstemperatur liegt.

4. Verfahren nach einem der vorangehenden Ansprüche, wobei die erste Temperatur oberhalb einer Verflüssigungstemperatur liegt, bei der das Kontaktierungsmaterial auf dem Substrat eine flüssige Phase bildet und wobei die Fertigungsumgebungstemperatur mehrere hundert Kelvin unterhalb der Verflüssigungstemperatur liegt.

5. Verfahren nach einem der vorangehenden Ansprüche, wobei das Kontaktierungsmaterial Metall aufweist.

6. Verfahren nach einem der vorangehenden Ansprüche, wobei das Kontaktierungsmaterial Aluminium aufweist.

7. Verfahren nach einem der vorangehenden Ansprüche, wobei das Kontaktierungsmaterial in Form einer metallhaltigen Siebdruckpaste auf die Oberfläche des Halbleiterbauelementsubstrats aufgebracht wird.

8. Verfahren nach einem der vorangehenden Ansprüche 5 bis 7, wobei die erste Temperatur oberhalb einer Eutektischer-Punkt-Temperatur liegt, so dass das Metall mit dem Material des Halbleiterbauelementsubstrats eine Legierung oder ein Eutektikum bildet, und wobei die Fertigungsumgebungstemperatur mehrere hundert Kelvin unterhalb der Eutektischer-Punkt-Temperatur liegt, bei der die Legierung oder das Eutektikum erstarrt.

9. Verfahren nach einem der vorangehenden Ansprüche, wobei das Kontaktierungsmaterial nach dem Erhitzen auf die erste Temperatur und einem anschließenden Abkühlen auf die Fertigungsumgebungstemperatur einen thermischen Ausdehnungskoeffizienten hat, der größer ist als der thermische Ausdehnungskoeffizient des Materials des Halbleiterbauelementsubstrats.

10. Verfahren nach einem der vorangehenden Ansprüche, wobei das Abkühlen des Kontaktierungsmaterials auf die zweite Temperatur zumindest teilweise durch Einbringen desselben in einen Raum, dessen Wände auf die zweite Temperatur oder darunter gekühlt werden, durchgeführt wird.

11. Verfahren nach einem der vorangehenden Ansprüche, wobei das Abkühlen des Kontaktierungsmaterials auf die zweite Temperatur zumindest teilweise durch Umgeben desselben mit einem Gas, das auf die zweite Temperatur oder darunter gekühlt wird, durchgeführt wird.

12. Verfahren nach einem der vorangehenden Ansprüche, wobei das Abkühlen des Kontaktierungsmaterials auf die zweite Temperatur zumindest teilweise durch Aufbringen einer Flüssigkeit mit einer Temperatur bei oder unter der zweiten Temperatur oder eines Kältesprays auf das Halbleiterbauelementsubstrat und/oder auf das Kontaktierungsmaterial durchgeführt wird.

13. Verfahren nach einem der vorangehenden Ansprüche, wobei das Abkühlen des Kontaktierungsmaterials auf die zweite Temperatur zumindest teilweise in der selben Vorrichtung wie dessen Erhitzen auf die erste Temperatur durchgeführt wird.

14. Verfahren nach einem der vorangehenden Ansprüche, wobei das Halbleiterbauelementsubstrat ein Siliziumwafer und das Halbleiterbauelement eine Siliziumsolarzelle ist.

15. Verfahren nach Anspruch 14, wobei der Siliziumwafer eine Dicke von weniger als 250µm, vorzugsweise weniger als 200µm, stärker bevorzugt weniger als 150µm, aufweist.

16. Halbleiterbauelement mit auf einem Substrat (3) flächig aufgebrachtem Metallkontakt (13), herstellbar mittels eines Verfahrens gemäß einem der Ansprüche 1 bis 15,
wobei der Metallkontakt (13) durch Abkühlen von einer Verflüssigungstemperatur, bei der das Material des Metallkontaktes (13) auf dem Material des Substrats (3) eine flüssige Phase bildet, auf eine Temperatur unterhalb einer Erstarrungstemperatur, bei der die flüssige Phase erstarrt, mit einer Oberfläche des Substrats (3) verbunden ist,
wobei das Material des Metallkontaktes (13) einen größeren thermischen Ausdehnungskoeffizienten hat als das Material des Substrats (3), und
wobei das Substrat (3) mit dem darauf aufgebrachten flächigen Metallkontakt (13) bei einer Fertigungsumgebungstemperatur weitgehend frei von mechanischen Spannungen ist.

17. Halbleiterbauelement nach Anspruch 16, wobei das Halbleiterbauelement mit dem darauf aufgebrachten flächigen Metallkontakt (13) nach dem Abkühlen derart weitgehend frei von mechanischen Spannungen ist, dass eine Durchbiegung des Halbleiterbauelements in einer Normalenrichtung normal zu dem flächigen Metallkontakt (13) weniger als 0,5%, vorzugsweise weniger als 0,2%, stärker bevorzugt weniger als 0,1 %, der Abmessung des Halbleiterbauelements in einer Parallelenrichtung parallel zu dem flächigen Metallkontakt (13) dividiert durch die Dicke des Halbleiterbauelements in der Normalenrichtung ist.

18. Halbleiterbauelement nach Anspruch 16 oder 17,wobei das Halbleiterbauelement mit dem darauf aufgebrachten flächigen Metallkontakt (13) nach dem Abkühlen derart weitgehend frei von mechanischen Spannungen ist, dass eine Durchbiegung des Halbleiterbauelements in einer Normalenrichtung normal zu dem flächigen Metallkontakt (13) weniger als 1,5mm, vorzugsweise weniger als 1,0mm und stärker bevorzugt weniger als 0,5mm ist.

19. Halbleiterbauelement nach einem der Ansprüche 16 bis 18, wobei die weitgehende mechanische Spannungsfreiheit bei Fertigungsumgebungstemperatur durch ein Abkühlen des Metallkontaktes (13) auf eine Temperatur, die mindestens 25K, vorzugsweise mindestens 65K, unterhalb der Fertigungsumgebungstemperatur des Halbleiterbauelements liegt, erreicht wird.

20. Halbleiterbauelement nach einem der Ansprüche 16 bis 19, wobei die weitgehende mechanische Spannungsfreiheit durch ein plastisches Recken des Metallkontakts (13) erreicht ist.

21. Halbleiterbauelement nach einem der Ansprüche 16 bis 20, wobei das Halbleiterbauelement eine Siliziumsolarzelle (1) einer Dicke von weniger als 200µ m ist und der Metallkontakt (13) aluminiumhaltig ist und bei mehr als 577°C einlegiert wurde und anschließend auf unter 0°C, vorzugsweise unter -40°C, abgekühlt wurde.

22. Vorrichtung zum Verbinden eines auf eine Oberfläche eines Halbleiterbauelementsubstrats aufgebrachten Metallkontaktmaterials mit dem Substrat aufweisend:
eine Heizzone (29), die dazu ausgelegt ist, das Metallkontaktmaterial auf eine Temperatur oberhalb einer Verflüssigungstemperatur zu heizen, bei der das Metallkontaktmaterial auf dem Substrat eine flüssige Phase bildet,
eine Kühlzone (43), die dazu ausgelegt ist, das auf das Substrat aufgebrachte Metallkontaktmaterial auf eine Kühltemperatur von weniger als 25K, vorzugsweise weniger als 65K, unterhalb einer die Vorrichtung umgebenden Umgebungstemperatur abzukühlen.

23. Vorrichtung nach Anspruch 22, wobei die Heizzone (29) dazu ausgelegt ist, den Metallkontakt auf über 660°C zu heizen und die Kühlzone (43) dazu ausgelegt ist, den Metallkontakt auf unter 0°C, vorzugsweise unter -40°C, abzukühlen.

24. Vorrichtung nach Anspruch 22 oder 23, wobei ein Fördergürtel (27, 41) vorgesehen ist, um das Halbleiterbauelementsubstrat von der Heizzone (29) in die Kühlzone (43) zu transportieren.

25. Vorrichtung nach einem der Ansprüche 22 bis 24, wobei ein Fördergürtel (27) vorgesehen ist, um das Halbleiterbauelementsubtrat durch die Heizzone (29) hindurch zu transportieren und ein weiterer Fördergürtel (41) dazu vorgesehen ist, das Halbleiterbauelementsubtrat anschließend durch die Kühlzone (43) zu transportieren.

26. Vorrichtung nach einem der Ansprüche 22 bis 25, wobei die Kühlzone (43) Kühlflächen (45,47) aufweist, die auf oder unter die Kühltemperatur kühlbar sind.

27. Vorrichtung nach Anspruch 26, wobei die Kühlflächen (45,47) dunkel, vorzugsweise schwarz, sind.

28. Vorrichtung nach einem der Ansprüche 22 bis 27, wobei die Kühlzone (45) eine Gaszuführung aufweist, um das Metallkontaktmaterial durch Zuleiten eines Gas mit einer Temperatur bei oder unterhalb der Kühltemperatur zu kühlen.

29. Vorrichtung nach einem der Ansprüche 22 bis 28, wobei die Kühlzone (45) eine Flüssigkeitszuführung aufweist, um das Metallkontaktmaterial durch Zuleiten einer Flüssigkeit mit einer Temperatur bei oder unterhalb der Kühltemperatur oder durch Zuleiten eines Kältesprays zu kühlen.
